# EUROPEAN PATENT APPLICATION

(11) **EP 2 403 143 A1**
(43) Date of publication of application: **04.01.2012**
(21) Application number: 11170918.4
(22) Date of filing: 22.06.2011
(51) Int. Cl.: H03K 17/10, H03K 17/12, H03K 17/0814, H01H 59/00, H01H 9/54

(54) **Method for minimizing parasitics in a switching array and such switching array**

(30) Priority: 29.06.2010 US 825420
(71) Applicant: General Electric Company, Schenectady, NY 12345 (US)
(72) Inventor: Keimel, Christopher Fred, Niskayuna, NY New York 12309 (US); Subramanian, Kanakasabapathi, 600017 Chennai (IN); Park, John N., Niskayuna, NY New York 12309 (US); Premerlani, William James, Scotia, NY New York 12302 (US); Schelenz, Owen Jannis Samuel, Niskayuna, NY New York 12309 (US)
(74) Representative: Illingworth-Law, William Illingworth

(57) **Abstract**

A switching array (14) includes a plurality of switching elements (12) electrically coupled to each other, each switching element (12) being configured to be switched between conducting and non-conducting states. The switching array (14) also includes at least one parasitic minimizing circuitry (20) electrically coupled to the plurality of switching elements (12) and configured to provide near zero electrical voltage and current across and through each of the plurality of switching elements (12) during switching of the plurality of switching elements (12) between the conducting and non-conducting states.

## Description

### BACKGROUND

The invention relates generally to an array including switching elements and more particularly to an array of solid state/micro electromechanical switches.

Switches are selectively switched between conducting and non-conducting states to supply desirable power to various types of applications. However, individual switches have a limited switching capability and are unable to switch power of high magnitude. As a result, high power switching is typically accomplished by employing an array of switches.

Switches may be turned "on" or "off" by voltage or current. Typically, an array of switches suffers from switching parasitics. For example, the array may exhibit an inherent variation in switching time. An inherent variation in switching time may result in excess switching load in the slower switches of the array. Excess power load may be detrimental to switch performance and life in the switching array. Therefore, the power switching capability of the switching array is often overly constrained to balance the switch performance and life with the switching capability of the switching array. Overly constrained operation of the switching array results in reduced efficiency and use of larger than desired switching arrays with increased complexity and expense. Sometimes, an over-sized array may not scale its switching rating beyond a point if, for instance, the slowest switch is the limiting switch. Other parasitic effects during switching may be due to non-zero and unequal inductances and capacitances in the switch array. This may lead to undesired current and/or voltage sharing issues, resulting in inefficiencies such as those described above.

Therefore, there is a need for an improved switching array to address the aforementioned issues.

### BRIEF DESCRIPTION

In accordance with an embodiment of the invention, a switching array is provided. The switching array includes a plurality of switching elements electrically coupled to each other, each switching element being configured to be switched between conducting and non-conducting states. The switching array also includes at least one parasitics minimizing circuitry electrically coupled to the plurality of switching elements.

In accordance with another embodiment of the invention, a method for retrofitting a switching array including a plurality of switching elements electrically coupled to each other, each switching element being configured to be switched between conducting and non-conducting states, is provided. The method includes electrically coupling at least one parasitics minimizing circuitry to the plurality of switching elements.

In accordance with another embodiment of the invention, a method for operation of a switching array is provided. The method includes providing a plurality of switching elements electrically coupled to form a switching array in a conducting or a non-conducting state. The method also includes activating a parasitics minimizing circuitry. The method further includes actuating the plurality of switching elements in the switching array from the conducting state to the non-conducting state or from the non-conducting state to the conducting state.

### DRAWINGS

These and other features, aspects, and advantages of the present invention will become better understood when the following detailed description is read with reference to the accompanying drawings in which like characters represent like parts throughout the drawings, wherein:
FIG. 1 is a schematic representation of a conventional switching array including a plurality of switching elements depicting inherent variation in time of switching of the plurality of switching elements resulting in an excess load on a remote switching element in the switching array.
FIG. 2 is a schematic illustration of the switching array of FIG. 1 including a parasitics minimizing circuit coupled to the plurality of switching elements in the switching array in accordance with an embodiment of the invention.
FIG. 3 is a block diagram representation of a single switching element coupled to the parasitics minimizing circuit in the switching array of FIG. 2 in accordance with an embodiment of the invention.
FIG. 4 is a block diagram representation of one embodiment of the parasitics minimizing circuit of FIG 3 including at least one mechanical bypass switch coupled to the switching element in accordance with an embodiment of the invention.
FIG. 5 is a detailed schematic representation of the switching array including the plurality of switching elements coupled to the parasitics minimizing circuit in a conducting state in the switching array of FIG. 2 in accordance with an embodiment of the invention.
FIG. 6 is a detailed schematic representation of the switching array including the plurality of switching elements coupled to the parasitics minimizing circuit in a non-conducting state in the switching array of FIG. 4 in accordance with an embodiment of the invention.
FIG. 7 is a flow chart representing the steps involved in a method for operation of a switching array of FIG. 5 including the plurality of switches coupled to at least one parasitics minimizing circuit in accordance with an embodiment of the invention.

### DETAILED DESCRIPTION

As discussed in detail below, embodiments of the present invention include a switching array, a method for minimizing parasitics of the switching array, and a method of operation of the switching array. The switching array includes a plurality of switching elements electrically coupled to each other, each switching element being configured to be switched between conducting and non-conducting states. The switching array also includes at least one parasitic minimizing circuitry electrically coupled to the plurality of switching elements and, in one embodiment, configured to provide a near zero electric power across each of the plurality of switching elements during switching of the plurality of switching elements.

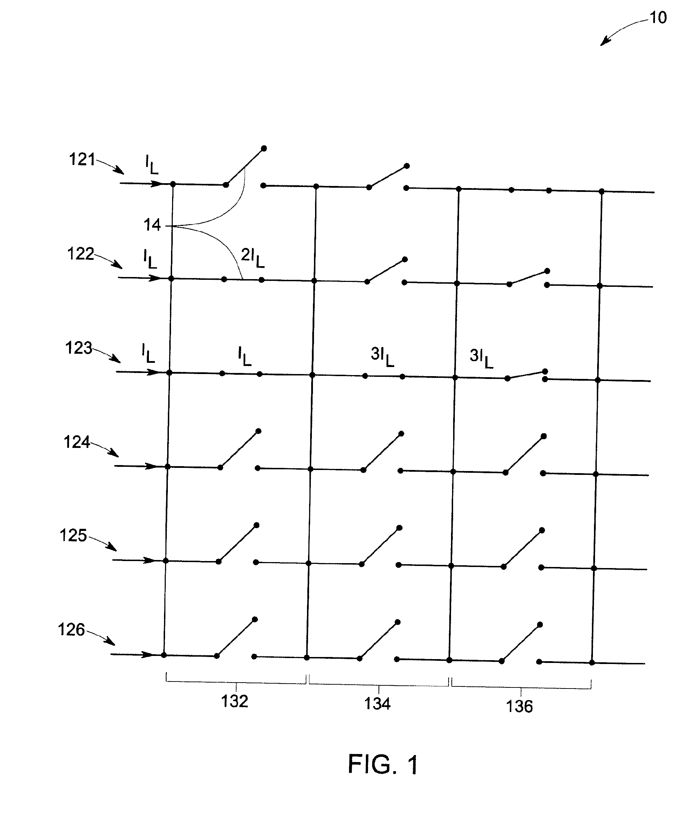

FIG. 1 is a schematic representation of a conventional switching array 10 including a plurality of switching elements 12. The switching elements 12 are electrically coupled together to form the switching array 10. The term "switching element" refers to a discrete device including at least 2 distinct conducting paths whose resistance and states can be modulated either individually or in combination. For better understanding of the figure, the switching array is divided into rows 121, 122, 123, 124, 125 and 126 and columns 132, 134 and 136. Generally, the switching array 10 includes a "switching rating." The "switching rating" refers to a maximum current and voltage switching capacity of the switching array 10. The current and the voltage flowing within the switching array 10 are referred to as a "load" of the switching array 10. The current flowing within the switching array 10 is referred to as a load current *I_{L}.* In an event of electric switching, the switching elements 12 are configured to switch between conducting and non-conducting states. A switching element 12 is said to be in a conducting state when the current I_{L} can flow in the switch from an input to an output of the switch. The non-conducting state of a switching element is a state when the current is unable to flow through the switching element.

While switching between states, the switching elements 12 experience parasitic effects. The parasitic effects may include an inherent variation in time. The inherent variation in time results in different positions of the plurality of switching elements at a particular instant during a switching event.

For example, in the switching event illustrated by FIG. 1, the distance between contacts of the switch at row 121, col 132 is longer than the distance between the contacts of the switch at row 122, col 134. Furthermore, switches in rows 124-126 are in open states whereas switches in rows 122-123 are in open and closed states. This variation in time and position of the plurality of switching elements during the switching event results in an excessive load at a remote switch (such as the switch at row 123, col 136). As commonly known, the load current *I_{L}* will seek the path of lowest resistance in the switching array. Therefore, the load current *I_{L}* diverts from row 121 to row 122 as the switching element at row 121, col 132 is in a non conducting state and provides high resistance to the load current *I_{L}* Furthermore, the load current *I_{L}* at switching element of row 122, col 132 increases to 2*I_{L}*. When the switch at row 122, col 134 is in a transition phase from a conducting state to a non conducting state, the increasing resistance the load current *I_{L}* will divert from the switch at row 122, col 134 to a switch at row 123, col 134 which is presently in a conducting state. Consequently, the load current *I_{L}* at the remote switch at row 123, col 136 increases to 3*I_{L}* resulting in a higher load at the remote switch.

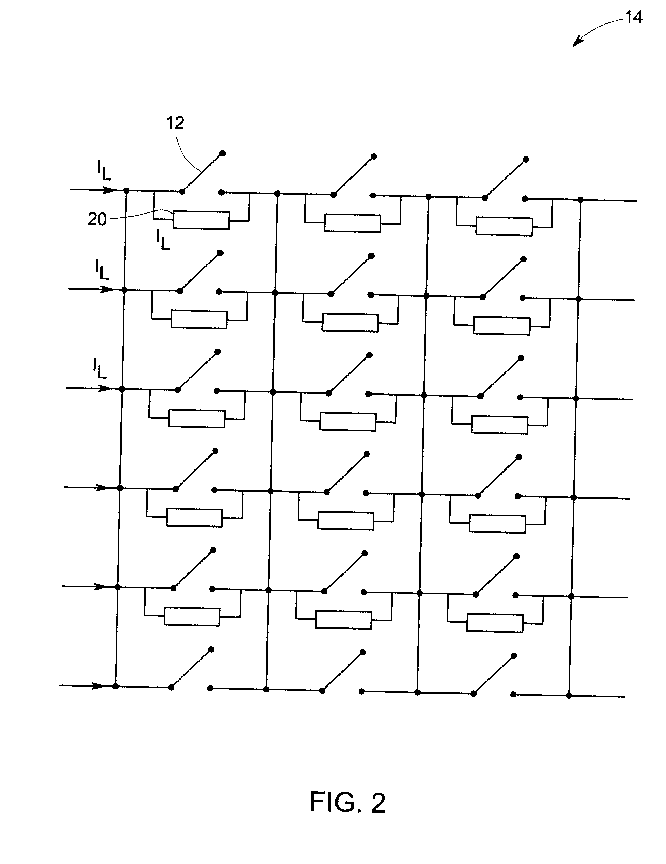

Therefore, it is evident that the parasitic effects in the switching array 10 result in higher load including high voltage and current at the remotest switches in the switching array 10. The high load voltage and current leads to decreased life and performance of the switches 12. Furthermore, to maintain the life and performance of the switches 12, it is necessary to reduce the high voltage and current flow at the switches 12. The voltage and current at the switching elements 12 may be reduced by reducing the parasitic effects of the switching array 10. This is achieved by coupling a parasitics minimizing circuitry, to the plurality of switching elements 12 to reduce the parasitic effects of the switching array 10. The switching array 10 including the parasitic minimizing circuitry is discussed in greater detail with respect to FIG. 2 below.

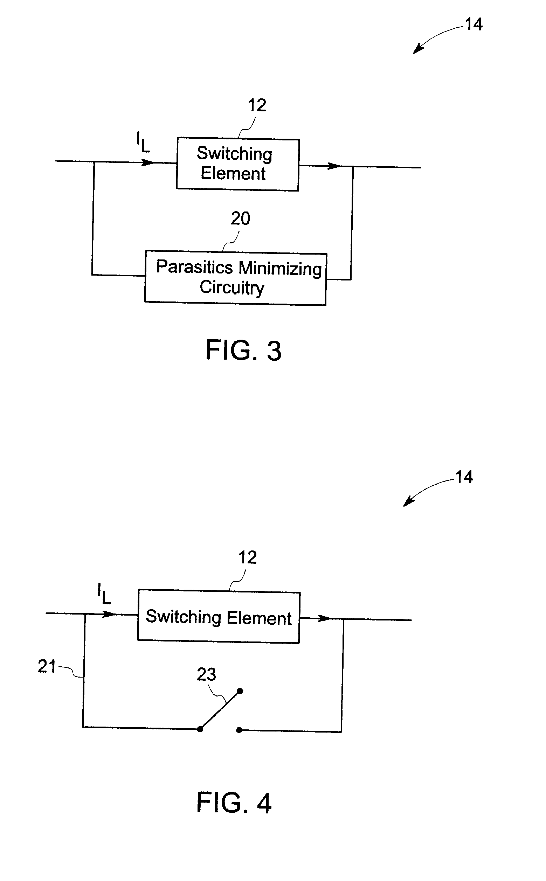

FIG. 2 is a schematic illustration of the switching array 14 including a parasitic minimizing circuitry 20 coupled to the plurality of switching elements 12 in the switching array 14 in accordance with an embodiment of the invention. The switching array 14 includes the plurality of switching elements 12 electrically coupled to each other. Each of the switching elements 12 is configured to switch between a conducting and a non-conducting state. At least one parasitic minimizing circuitry 20 is electrically coupled to the plurality of switching elements 12. In one embodiment, the parasitic minimizing circuitry includes a bypass circuit that bypasses the electric power across each of the plurality of switching elements 12 a few microseconds prior to switching of the plurality of switching elements 12. The parasitic minimizing circuitry 20 may be coupled in parallel to the plurality of switching elements 12. The coupling of the plurality of switching elements 12 and the parasitic minimizing circuitry 20 can be better understood with respect to FIG. 3 described below.

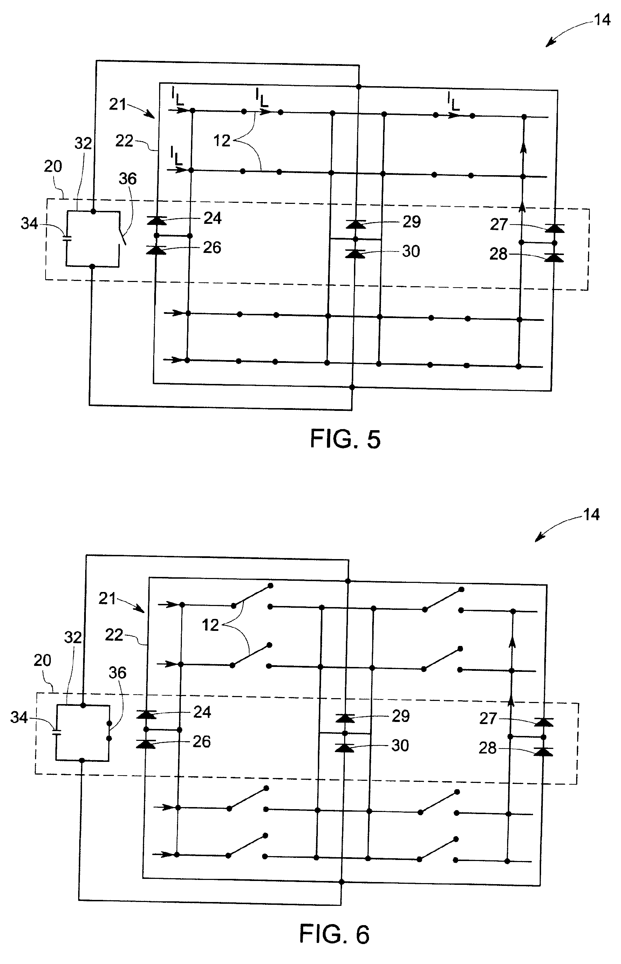

FIG. 3 is a block diagram representation of one switching element 12 coupled to the parasitic minimizing circuitry 20 in the switching array 14 of FIG. 2 in accordance with an embodiment of the invention. The parasitic minimizing circuitry 20 is coupled to the switching element 12 in parallel in this embodiment such that the input load current *I_{L}* at the switching element 12 flows via the parasitic minimizing circuitry 20 for a predetermined period of time prior to the switching of the switching element 12 between the conducting and non conducting states. In a particular embodiment, the predetermined period occurs a few microseconds to 10's of microseconds. For simplicity and better understanding of the invention, one switching element 12 coupled to the parasitic minimizing circuitry 20 is shown. However, a plurality of switching elements 12 can be coupled to one parasitic minimizing circuitry 20 as shown in FIG. 5 below, for example.

FIG. 4 is a block diagram representation of one embodiment of the parasitic minimizing circuitry 20 of FIG. 3 including a mechanical bypass switch 23 in accordance with an embodiment of the invention. In the embodiment shown in FIG. 4, the parasitic minimizing circuitry 20 provides a low resistance path 21 coupled in parallel to each of the plurality of switching elements 12. In an embodiment, the low resistance path comprises a differential voltage drop between two points in the bypass circuit. In an exemplary embodiment, the low resistance path 21 may be provided by at least one mechanical bypass switch 23. The at least one mechanical bypass switch 23 is controlled by a logic circuit and is actuated prior to the switching event from non-conducting state to conducting state to provide a low resistance path 21 to bypass the current via the mechanical switch 23 and provide a near zero voltage and current at the switching element 12 during switching.

FIG. 5 is a detailed schematic representation of the switching array 14 including the plurality of switching elements 12 coupled to the parasitic minimizing circuitry 20 in a conducting state in the switching array 14 of FIG. 2 in accordance with an embodiment of the invention. The plurality of switching elements 12 includes micro electromechanical switches, solid-state switches, or a combination of electromechanical and solid state switches. Non-limiting examples of solid state switches include metal-oxide semiconductor field-effect transistors, silicon controlled rectifiers, and insulated gate bipolar transistors, bipolar junction transistor, germanium bipolar transistor, triode alternating current switch, diode alternating current switch, silicon diode alternating current switch, hetero-junction bipolar transistor, silicon germanium hetero-junction bipolar transistor, gallium field-effect transistor, metal oxide semiconductor switch, metal oxide semiconductor controlled thyristor, gate turnoff thyristor and solidtrons. In an exemplary embodiment, the plurality of switching elements 12 is electrically coupled in series or in parallel or in a combination thereof. For simplicity and better understanding of the invention, one parasitic minimizing circuitry 20 is shown as coupled to a few switching elements 12 in a portion of the switching array 14. However, one parasitic minimizing circuitry may be coupled to more switches and/or multiple parasitic minimizing circuitry units may be used.

The low resistance path 21 may be provided by a balanced diode bridge 22 configured to bypass the input load current *I_{L}* at the plurality of switching elements 12. As used herein, the term "balanced diode bridge 22" includes a first branch and a second branch. The first branch of the balanced diode bridge 22 includes a first diode 24 and a second diode 26 coupled together in series. In a similar fashion, the second branch may include a third diode 27 and a fourth diode 28 operatively coupled together in series. Furthermore, the voltage drop across the first branch and the second branch is substantially equal resulting in a path with the low resistance.

The parasitic minimizing circuitry 20 may further include one or more intermediate diodes coupled to the switching array 14 such that the intermediate diodes 29 and 30 are used to balance a residual voltage at the mid points of the switching array 14. The diode bridge 22 may be unable to protect intermediate points from the residual voltage left in the switching array 14 and therefore, the intermediate diodes may be provided in the switching array.

In one embodiment, the parasitic minimizing circuitry 20 also includes a pulse circuit 32 including a pulse capacitor 34 configured to form a pulse signal for causing flow of a pulse current through the balanced diode bridge 22. In one embodiment, the pulse circuit 32 includes a pulse switch 36. In an exemplary embodiment, the pulse switch 36 may be a solid-state switch that may be configured to have switching speeds in the range of several nanoseconds to several microseconds. The pulse circuit 32 is configured to detect a switching event via a control logic signal. As used herein, the term "switching event " refers to a condition that triggers changing present operating states of the switching elements 12 of the switching array. The operating states include the conducting state and the non-conducting state. The pulse signal is generated in connection with the switching event. In one embodiment, the plurality of switching elements 12 and the balanced diode bridge 22 may be disposed such that a total inductance between the switching elements 12 and the parasitic minimizing circuitry 20 is less than or equal to a product of a characteristic timing spread and a minimum characteristic resistance of the switching array 14. One example of a characteristic time is less than or equal to about 15 microseconds. Furthermore, In one embodiment the parasitics minimizing circuitry may be operated in a similar manner as described with respect to a commutation circuit in commonly assigned US7554222, which is herein incorporated by reference in its entirety.

FIG. 6 is a detailed schematic representation illustrating current pathways when switching to the non-conducting state is initiated in the switching array 14 of FIG. 5 in accordance with an embodiment of the invention. The pulse switch 36 is triggered prior to opening of the switching elements 12 and generates a resonant half-sinusoidal pulse current *I_{PULSE}.* As the pulse current *I_{PULSE}* increases, the voltage across a pulse capacitor 34 decreases due to the resonant action of the pulse circuit 32. However, in the conducting state, the switching elements 12 present a path of relatively low impedance for the load current *I_{L}* flowing through the switching array 14.

Once the amplitude of the pulse current *I_{PULSE}* becomes sufficiently greater than the amplitude of the load circuit current *I_{L}* (*e.g.*, due to the resonant action of the pulse circuit), a gate voltage can be applied to the switching elements 12 to switch the present operating state of the switching elements 12 from the conducting state to an increasing resistance condition of the non conducing state. This causes the characteristic switch resistance to increase, which in turn causes the load current *I_{L}* to start to divert from the switching elements 12 into the parasitic minimizing circuitry 20. In this embodiment, the balanced diode bridge 22 presents a path of relatively low impedance to the load current *I_{L}* as compared to a path through the switching elements 12, which is now associated with an increasing characteristic resistance. It may be noted that this diversion of load current *I_{L}* from the switching elements 12 is an extremely fast process compared to the rate of change of the load circuit current *I_{L}* In one embodiment of the invention, the balanced diode bridge 22 may enable the switching elements 12 to be rapidly switched (*e.g.*, on the order of nanoseconds to microseconds) from the conducting state to the non-conducting state while carrying a current at about a near-zero voltage.

Consequent to the load current *I_{L}* being diverted to the balanced diode bridge 22, an imbalance forms within the diode bridge 22 as the current in each of the first diode 24 and the fourth diode 30 increases, while, simultaneously, the current in each of the second diode 26 and the third diode 28 is diminished. Furthermore, as the pulse current *I_{PULSE}* decays, voltage across the pulse capacitor 34 continues to reverse (*e.g.*, acting as a "back electromotive force") which causes the eventual reduction of the load current *I_{L}* to zero. However, the diode bridge 22 may be configured to maintain a near-zero voltage across the switching elements 12 until the switching elements 12 switch completely to the non-conducting state.

The near zero voltage and current at the switching elements 12 during switching enables the switching elements 12 to switch power of an increased magnitude. The increased magnitude of power can be switched, as the magnitude would make an insignificant difference to the power switched via the switching elements, when the switches experience near zero voltage and current at the time of switching.

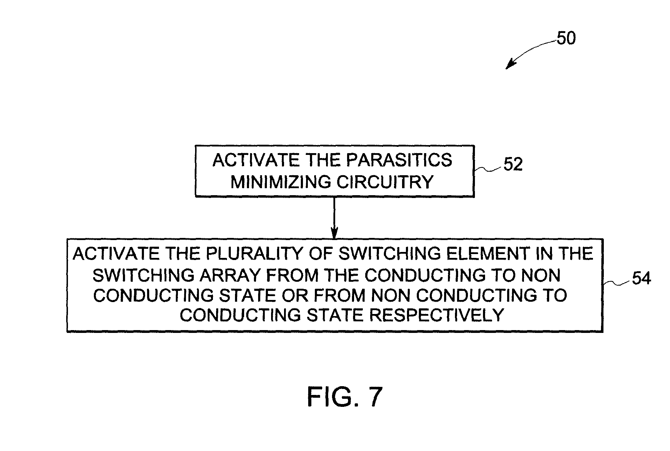

FIG. 7 is a flow chart representing the steps involved in a method for operation of a switching array including a plurality of switching elements electrically coupled to form a switching array in a conducting or a non-conducting state and at least one parasitic minimizing circuitry electrically coupled to the plurality of switching elements of FIG. 6 in accordance with an embodiment of the invention. The method 50 includes activating the parasitic minimizing circuitry at step 52. Furthermore, the plurality of switching elements in the switching array are actuated from the conducting to non-conducting state or from the non-conducting to a conducting state respectively at step 54. In an embodiment, the electric power is bypassed via a low resistance path. In another embodiment, the low resistance path may include a mechanical switch.

Parasitics minimizing circuitry may be applied to newly manufactured switching arrays or to existing arrays. For example, at least one parasitic minimizing circuitry may be electrically coupled to a plurality of switching elements in an existing switch array and be configured to bypass the electric power across each of the plurality of switching elements prior to switching of the plurality of switching elements. In one embodiment, a low resistance path is coupled in parallel to the plurality of switching elements. In another embodiment a mechanical switch may be coupled in parallel to the plurality of switching elements.

The various embodiments of a switching array described above include a plurality of switching elements electrically coupled to a parasitic minimizing circuitry to bypass power from the plurality of switching elements prior to switching. Thus, these techniques enable scaling of the switching rating of the switching array that is particularly useful for high power switching. Furthermore, existing switching arrays can be upgraded to operate in high power switching conditions by adding a parasitic minimizing circuitry and modifying control systems as described herein.

Of course, it is to be understood that not necessarily all such objects or advantages described above may be achieved in accordance with any particular embodiment. Thus, for example, those skilled in the art will recognize that the systems and techniques described herein may be embodied or carried out in a manner that achieves or optimizes one advantage or group of advantages as taught herein without necessarily achieving other objects or advantages as may be taught or suggested herein.

Furthermore, the skilled artisan will recognize the interchangeability of various features from different embodiments. For example, at least one mechanical bypass switch with respect to one embodiment can be adapted for use with the micro electromechanical devices described with respect to another embodiment of the invention to scale the switching rating of the switching array. Similarly, the various features described, as well as other known equivalents for each feature, may be mixed and matched by one of ordinary skill in this art to construct additional systems and techniques in accordance with principles of this disclosure.

While only certain features of the invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are defined by the following numbered clauses:
1. A switching array, comprising:
   a plurality of switching elements electrically coupled to each other, each switching element being configured to be switched between conducting and non-conducting states; and
   at least one parasitic minimizing circuitry electrically coupled to the plurality of switching elements and configured to provide near zero electrical voltage and current across and through each of the plurality of switching elements during switching of the plurality of switching elements between the conducting and non-conducting states.
2. The switching array of clause 1, wherein the parasitic minimizing circuitry comprises a bypass circuit.
3. The switching array of clause 1 or clause 2, wherein the bypass circuit changes from a high resistance state to a low resistance state and provides a low resistance path to bypass the electric power across each of the plurality of switching elements prior to switching of the plurality of switching elements.
4. The switching array of any preceding clause, wherein the parasitic minimizing circuitry is coupled in parallel to the plurality of switches.
5. The switching array of any preceding clause, wherein the low resistance path comprises at least one mechanical bypass switch.
6. The switching array of any preceding clause, wherein the low resistance path comprises at least one semiconductor device.
7. The switching array of any preceding clause, wherein the low resistance path comprises a differential voltage drop between two points in the bypass circuit.
8. The switching array of any preceding clause, wherein the plurality of switching elements comprises micro electromechanical switches, solid state switches, or a combination of electromechanical and solid state switches.
9. The switching array of any preceding clause, wherein the plurality of switching elements comprises metal-oxide semiconductor field-effect transistors, silicon controlled rectifiers, insulated gate bipolar transistors, or a combination thereof.
10. The switching array of any preceding clause, wherein the switching elements are electrically coupled in series, in parallel, or in a combination thereof.
11. A method for minimizing parasitics in a switching array comprising a plurality of switching elements electrically coupled to each other, each switching element being configured to be switched between conducting and non-conducting states, the method comprising;
   electrically coupling to the plurality of switching elements at least one parasitic minimizing circuitry configured for providing a near zero electric power across each of the plurality of switching elements during switching of the plurality of switching elements between the conducting and the non-conducting states.
12. The method of clause 11, wherein electrically coupling at least one parasitic minimizing circuitry to the plurality of switching elements comprises providing a bypass circuit coupled in parallel to the plurality of switching elements.
13. The method of clause 11 or clause 12, wherein providing the bypass circuit comprises providing a low resistance path coupled in parallel to the plurality of switching elements.
14. The method of any of clauses 11 to 13, wherein providing the low resistance path comprises providing a mechanical switch.
15. A method for operation of a switching array comprising a plurality of switching elements electrically coupled to form a switching array in a conducting or a non-conducting state and at least one parasitic minimizing circuitry electrically coupled to the plurality of switching elements, the method comprising:
   activating the parasitic minimizing circuitry; and then
   actuating the plurality of switching elements in the switching array from the conducting to non-conducting state or from the non-conducting to a conducting state respectively. ;
16. The method of clause 15, wherein activating the switching rating circuitry comprises providing a near zero electric power across each switching element among the plurality of switching elements during switching of the corresponding switch among the plurality of switches.
17. The method of clause 15 or clause 16, wherein providing a near zero electric power across each switch among the plurality of switches comprises bypassing the electric power via a low resistance path coupled in parallel to the plurality of switches.
18. The method of any of clauses 15 to 17, wherein bypassing the electric power via the low resistance path comprises bypassing the electric power via a mechanical switch.

## Claims

1. A switching array (14), comprising:
a plurality of switching elements (12) electrically coupled to each other, each switching element (12) being configured to be switched between conducting and non-conducting states; and
at least one parasitic minimizing circuitry (20) electrically coupled to the plurality of switching elements (12) and configured to provide near zero electrical voltage and current across and through each of the plurality of switching elements (12) during switching of the plurality of switching elements (12) between the conducting and non-conducting states.

2. The switching array (14) of claim 1, wherein the parasitic minimizing circuitry (20) comprises a bypass circuit.

3. The switching array (14) of claim 1 or claim 2, wherein the bypass circuit changes from a high resistance state to a low resistance state and provides a low resistance path (21) to bypass the electric power across each of the plurality of switching elements (12) prior to switching of the plurality of switching elements (12).

4. The switching array (14) of any preceding claim, wherein the low resistance path (21) comprises at least one mechanical bypass switch (23).

5. The switching array (14) of any preceding claim, wherein the low resistance path (21) comprises at least one semiconductor device.

6. The switching array (14) of any preceding claim, wherein the low resistance path (21) comprises a differential voltage drop between two points in the bypass circuit.

7. The switching array of any preceding claim, wherein the plurality of switching elements comprises micro electromechanical switches, solid state switches, or a combination of electromechanical and solid state switches.

8. The switching array of any preceding claim, wherein the plurality of switching elements comprises metal-oxide semiconductor field-effect transistors, silicon controlled rectifiers, insulated gate bipolar transistors, or a combination thereof.

9. The switching array of any preceding claim, wherein the switching elements are electrically coupled in series, in parallel, or in a combination thereof.

10. A method for minimizing parasitics in a switching array (14) comprising a plurality of switching elements (12) electrically coupled to each other, each switching element (12) being configured to be switched between conducting and non-conducting states, the method comprising;
electrically coupling to the plurality of switching elements (12) at least one parasitic minimizing circuitry (20) configured for providing a near zero electric power across each of the plurality of switching elements (12) during switching of the plurality of switching elements (12) between the conducting and the non-conducting states.

11. The method of claim 10, wherein electrically coupling at least one parasitic minimizing circuitry (20) to the plurality of switching elements (12) comprises providing a bypass circuit coupled in parallel to the plurality of switching elements (12).

12. The method of claim 10 or claim 11, wherein providing the bypass circuit comprises providing a low resistance path coupled in parallel to the plurality of switching elements.

13. The method of any of claims 10 to 12, wherein providing the low resistance path comprises providing a mechanical switch.

14. A method for operation of a switching array (14) comprising a plurality of switching elements (12) electrically coupled to form a switching array (14) in a conducting or a non-conducting state and at least one parasitic minimizing circuitry (20) electrically coupled to the plurality of switching elements (12), the method comprising:
activating the parasitic minimizing circuitry (20) ; and then
actuating the plurality of switching elements (12) in the switching array (14) from the conducting to non-conducting state or from the non-conducting to a conducting state respectively. ;

15. The method of claim 14, wherein activating the parasitic minimizing circuitry (20) comprises providing a near zero electric power across each switching element (12) among the plurality of switching elements (12) during switching of the corresponding switch among the plurality of switching elements (12).
